# EUROPEAN PATENT APPLICATION

(11) **EP 4 465 531 A1**
(43) Date of publication of application: **20.11.2024**
(21) Application number: 24172751.0
(22) Date of filing: 26.04.2024
(51) Int. Cl.: H02S 40/32, H02S 40/34, H02S 40/36

(54) **PHOTOVOLTAIC OPTIMIZER AND PHOTOVOLTAIC POWER GENERATION SYSTEM**

(30) Priority: 15.05.2023 CN 202310547940
(71) Applicant: Huawei Digital Power Technologies Co., Ltd., Shenzhen, Guangdong 518043 (CN)
(72) Inventor: HE, Li, 518043 Shenzhen (CN); CHEN, Zhangrui, 518043 Shenzhen (CN); WANG, Xiaohong, 518043 Shenzhen (CN); WANG, Jiawei, 518043 Shenzhen (CN)
(74) Representative: Gill Jennings & Every LLP

(57) **Abstract**

Embodiments of this application provide a photovoltaic optimizer and a photovoltaic power generation system. The photovoltaic optimizer includes a metal housing, a printed circuit board module, an end cover, and a cable. An input end of the cable is connected to the printed circuit board through at least one through hole. The photovoltaic optimizer has a simple structure and is easy to assemble. In addition, heat generated by a device mounted on the printed circuit board in the photovoltaic optimizer is dissipated to the outside of the metal housing through the metal housing.

## Description

### TECHNICAL FIELD

Embodiments of this application relate to the field of photovoltaic technologies, and specifically, to a photovoltaic optimizer and a photovoltaic power generation system.

### BACKGROUND

In a photovoltaic power generation system, a photovoltaic optimizer can implement maximum power tracking and fast shutdown of a photovoltaic module. A printed circuit board in an existing photovoltaic optimizer is disposed in an accommodation cavity of a plastic housing. In addition, a heat spreader and a heat sink need to be disposed in the plastic housing, to implement heat dissipation during operating of the photovoltaic optimizer. However, the photovoltaic optimizer has a complex structure, is not easy to assemble, and has high costs.

### SUMMARY

Embodiments of this application provide a photovoltaic optimizer and a photovoltaic power generation system. A printed circuit board in the photovoltaic optimizer is disposed in an accommodation cavity formed by an end cover and a metal housing that is a hollow structure having an opening, and a cable is connected to the printed circuit board through a through hole on the end cover. In this way, in an operating process of the photovoltaic optimizer, heat generated by a device mounted on the printed circuit board is dissipated to the outside of the metal housing through the metal housing. Further, the photovoltaic optimizer not only can ensure good heat dissipation effect, but also has a simple structure, is easy to assemble, and has low costs. Correspondingly, costs of the photovoltaic power generation system are also low.

According to a first aspect, an embodiment of this application provides a photovoltaic optimizer. The photovoltaic optimizer includes a metal housing, a printed circuit board module, an end cover, and a cable. The metal housing is a hollow structure having an opening. The end cover is configured to cover the opening of the metal housing to form an accommodation cavity, the accommodation cavity is configured to accommodate the printed circuit board module, and the end cover includes at least one through hole. The printed circuit board module includes a printed circuit board and at least one device mounted on the printed circuit board. An input end of the cable is connected to the printed circuit board through at least one through hole.

The printed circuit board in the photovoltaic optimizer provided in this embodiment of this application is disposed in the accommodation cavity formed by the end cover and the metal housing that is a hollow structure having an opening, and the cable is connected to the printed circuit board through the through hole on the end cover. In this way, the photovoltaic optimizer has a simple structure and is easy to assemble. In addition, heat generated by a device mounted on the printed circuit board in the photovoltaic optimizer is dissipated to the outside of the metal housing through the metal housing, so that good heat dissipation effect of the photovoltaic optimizer is achieved. In this way, costs of the photovoltaic power generation system are reduced.

In an implementation, a limiting structure is disposed on an inner wall of the metal housing, and the limiting structure cooperates with the printed circuit board module to prevent the printed circuit board module from moving in a direction parallel to the end cover.

In an implementation, the limiting structure includes a first protrusion and a second protrusion that protrude from a first inner wall of the metal housing to a second inner wall of the metal housing, and a third protrusion and a fourth protrusion that protrude from the second inner wall of the metal housing to the first inner wall of the metal housing. A first part of the printed circuit board module is accommodated between the first protrusion and the second protrusion, and a second part of the printed circuit board module is accommodated between the third protrusion and the fourth protrusion. A distance between a wall that is of the first protrusion and that is close to the second protrusion and a wall that is of the second protrusion and that is close to the first protrusion is equal to a size that is of the first part of the printed circuit board module and that is in a direction perpendicular to a third inner wall of the metal housing. A distance between a wall that is of the third protrusion and that is close to the fourth protrusion and a wall that is of the fourth protrusion and that is close to the third protrusion is equal to a size that is of the second part of the printed circuit board module and that is in a direction perpendicular to the third inner wall of the metal housing. The first inner wall of the metal housing and the second inner wall of the metal housing are arranged opposite to each other, and the third inner wall of the metal housing is perpendicular to both the end cover and the first inner wall of the metal housing. Correspondingly, the printed circuit board module is disposed in space formed by the first protrusion, the second protrusion, the third protrusion, and the fourth protrusion of the metal housing. The first protrusion, the second protrusion, the third protrusion, and the fourth protrusion in the inner wall of the metal housing cooperate with the printed circuit board module separately, so that movement of the printed circuit board module in a direction perpendicular to the third inner wall can be limited.

In an implementation, a size that is of the printed circuit board module and that is in a direction perpendicular to the first inner wall of the metal housing is equal to a distance between the first inner wall of the metal housing and the second inner wall of the metal housing. A distance between the first protrusion and the third inner wall of the metal housing is equal to a distance between the third protrusion and the third inner wall of the metal housing. A distance between the second protrusion and the third inner wall of the metal housing is equal to a distance between the fourth protrusion and the third inner wall of the metal housing. Correspondingly, the first inner wall and the second inner wall of the metal housing can limit movement of the printed circuit board module in a direction perpendicular to the first inner wall of the metal housing.

In an implementation, the limiting structure includes a first groove that is recessed, in a direction away from a second inner wall of the metal housing, from a first inner wall of the metal housing, and a second groove that is recessed, in a direction away from the first inner wall of the metal housing, from the second inner wall of the metal housing. A first part of the printed circuit board module is accommodated in the first groove, and a second part of the printed circuit board module is accommodated in the second groove. In addition, a size that is of the first groove and that is in a direction perpendicular to a third inner wall of the metal housing is equal to a size that is of the first part of the printed circuit board module and that is in a direction perpendicular to the third inner wall. A size that is of the second groove and that is in a direction perpendicular to the third inner wall of the metal housing is equal to a size that is of the second part of the printed circuit board module and that is in a direction perpendicular to the third inner wall. The second inner wall of the metal housing and the first inner wall of the metal housing are arranged opposite to each other. The third inner wall of the metal housing is perpendicular to both the end cover and the first inner wall of the metal housing. Correspondingly, the printed circuit board module is disposed in space formed by the first groove and the second groove of the metal housing, and the first groove and the second groove cooperate with the printed circuit board module separately, so that movement of the printed circuit board module in a direction perpendicular to the third inner wall can be limited.

In an implementation, a size that is of the printed circuit board module and that is in a direction perpendicular to the first inner wall of the metal housing is equal to a distance between a wall that is of the first groove and that is farthest from the second groove and a wall that is of the second groove and that is farthest from the first groove. In addition, a distance between the first groove and the third inner wall of the metal housing is equal to a distance between the second groove and the third inner wall of the metal housing. Correspondingly, the first groove and the second groove of the metal housing can limit movement of the printed circuit board module in a direction perpendicular to the first inner wall of the metal housing.

In an implementation, the printed circuit board module has a support. An accommodation groove that is recessed toward an interior of the support is disposed on the support, and the accommodation groove is configured to bear the printed circuit board module. Correspondingly, the printed circuit board module is borne in the support, and problems such as electromagnetic compatibility (electromagnetic compatibility, EMC) of photovoltaic optimization can be solved. In addition, a creepage distance of the printed circuit board module can be increased, so that the photovoltaic optimizer can better satisfy safety requirements.

In an implementation, an outer frame is wrapped around an edge that is of the printed circuit board module and that is not connected to the cable. The outer frame has a bearing channel that runs through the outer frame, and the bearing channel is configured to bear the printed circuit board module. Correspondingly, an edge of the printed circuit board module is wrapped by the outer frame, so that the problem of the EMC of the photovoltaic optimizer can be resolved. In addition, a creepage distance of the printed circuit board module can be increased, so that the photovoltaic optimizer can better satisfy safety requirements.

In an implementation, a material used by the support or the outer frame is a thermally conductive insulation material.

In an implementation, the photovoltaic optimizer further includes a first potting glue, and the first potting glue is configured to fill a gap between the inner wall of the metal housing and the printed circuit board module. Correspondingly, the first potting glue may seal the printed circuit board module in the metal housing, so that the printed circuit board module is isolated, and an objective of insulation of the printed circuit board module is achieved. In addition, the first potting glue may further transfer heat generated by a device on the printed circuit board to the metal housing, and then the heat is transferred to surrounding air outside the metal housing, so that a heat dissipation capability of the photovoltaic optimizer is enhanced.

In an implementation, the photovoltaic optimizer further includes a second potting glue, and the second potting glue is configured to fill a gap between the at least one through hole and the cable. Correspondingly, the accommodation cavity formed by the end cover covering the opening of the metal housing is a sealed accommodation cavity, so that the printed circuit board module accommodated in the accommodation cavity can be waterproofed and sealed.

In an implementation, the photovoltaic optimizer further includes a thermally conductive insulation film, and the thermally conductive insulation film is disposed on the inner wall of the metal housing. Correspondingly, the thermally conductive insulation film can transfer heat generated by the printed circuit board module to the metal housing, and then the heat is transferred to surrounding air outside the metal housing, so that a heat dissipation capability of the photovoltaic optimizer is enhanced.

In an implementation, the photovoltaic optimizer further includes a mounting ear structure, and the mounting ear structure is fastened to the metal housing. The mounting ear structure includes at least one mounting hole, and the at least one mounting hole is configured to mount the photovoltaic optimizer to a target structure.

In an implementation, the mounting ear structure and the metal housing are of an integrated structure. Correspondingly, by using the metal housing, the photovoltaic optimizer can not only implement heat dissipation of the photovoltaic optimizer, but can also be mounted on the target structure.

In an implementation, the photovoltaic optimizer further includes a connection structure, and the connection structure is configured to fasten and the end cover to the metal housing.

In an implementation, the connection structure includes a screw or colloid.

According to a second aspect, an embodiment of this application provides a photovoltaic power generation system. The photovoltaic power generation system includes the photovoltaic optimizer according to any one of the first aspect or the possible implementations of the first aspect and a photovoltaic module. An output end of the cable of the photovoltaic optimizer extends out of the metal housing to form a connector, and the connector is configured to connect the photovoltaic module.

For technical effect of the second aspect, refer to corresponding descriptions in the first aspect. Details are not described herein again.

### BRIEF DESCRIPTION OF DRAWINGS

FIG. 1 is a schematic diagram of a photovoltaic power generation system according to an embodiment of this application;
FIG. 2 is an exploded view of a photovoltaic optimizer according to an embodiment of this application;
FIG. 3 is a schematic diagram of an assembly of a photovoltaic optimizer according to an embodiment of this application;
FIG. 4 is a schematic diagram of an assembly between a metal housing and a printed circuit board module in the photovoltaic optimizer shown in FIG. 3;
FIG. 5 is a schematic diagram of an assembly of another photovoltaic optimizer according to an embodiment of this application;
FIG. 6 is a schematic diagram of an assembly between a metal housing and a printed circuit board module in the photovoltaic optimizer shown in FIG. 5;
FIG. 7 is an exploded view of a photovoltaic optimizer according to an embodiment of this application;
FIG. 8 is a schematic diagram of an assembly between a metal housing and a printed circuit board module having a support in the photovoltaic optimizer shown in FIG. 7;
FIG. 9 is a schematic diagram of another assembly between a metal housing and a printed circuit board module having a support in the photovoltaic optimizer shown in FIG. 7;
FIG. 10 is an exploded view of a photovoltaic optimizer according to an embodiment of this application;
FIG. 11 is a schematic diagram of an assembly between a metal housing and a printed circuit board module having a support in the photovoltaic optimizer shown in FIG. 10;
FIG. 12 is a schematic diagram of another assembly between a metal housing and a printed circuit board module having a support in the photovoltaic optimizer shown in FIG. 10;
FIG. 13 is an exploded view of a photovoltaic optimizer according to an embodiment of this application;
FIG. 14 is a schematic diagram of an assembly between a printed circuit board module having an outer frame and a cable in the photovoltaic optimizer shown in FIG. 13;
FIG. 15 is a schematic diagram of an assembly between a printed circuit board module having an outer frame and a metal housing in the photovoltaic optimizer shown in FIG. 13; and
FIG. 16 is a schematic diagram of another assembly between a printed circuit board module having an outer frame and a metal housing in the photovoltaic optimizer shown in FIG. 13.

### DESCRIPTION OF EMBODIMENTS

The following describes technical solutions of embodiments in this application with reference to accompanying drawings.

In the description of embodiments of this application, unless otherwise stated, "/" means "or", for example, A/B may represent A or B. The term "and/or" in this specification describes only an association relationship between associated objects, and indicates that three relationships may exist. For example, A and/or B may represent three cases: Only A exists, both A and B exist, and only B exists.

In embodiments of this application, prefix words such as "first", "second", "third", "fourth", and "fifth" are used only to distinguish between different described objects, and do not limit a location, a sequence, a priority, a quantity, content, or the like of the described objects. In embodiments of this application, use of a prefix word, such as an ordinal number, used to distinguish between described objects does not constitute a limitation on the described objects. For a description of the described objects, refer to the description of the context in the claims or embodiments. The use of such a prefix word should not constitute an unnecessary limitation. In the descriptions of embodiments, unless otherwise specified, "a plurality of" means two or more.

Reference to "some embodiments" or the like described in this specification means that one or more embodiments of this application include a specific feature, structure, or characteristic described in combination with embodiment. Therefore, statements such as "in some embodiments" that appear at different places in this specification do not necessarily mean referring to a same embodiment, instead, they mean "one or more but not all of embodiments", unless otherwise specifically emphasized. The terms "include", "comprise", and "have", and variants thereof all mean "include but are not limited to", unless otherwise specifically emphasized in another manner.

"Equal to" in this application is not equal to in a strict sense, but is within an allowed error range. "Flush with" is not a tangent in a strict sense, but within an allowed error range.

In embodiments of this application, a same reference numeral represents a same component or a same part. In embodiments of this application, for a plurality of identical parts, only one of the parts may be used as an example in the accompanying drawings to be marked with the reference numeral. For other identical parts, the reference numerals are also applicable. In addition, the dimensions and sizes of the parts shown in the accompanying drawings are merely used as examples.

In a photovoltaic power generation system, a photovoltaic optimizer can implement maximum power tracking and fast shutdown of a photovoltaic module. A printed circuit board in an existing photovoltaic optimizer is disposed in an accommodation cavity of a plastic housing. In addition, a heat spreader and a heat sink need to be disposed in the plastic housing, to implement heat dissipation during operating of the photovoltaic optimizer. However, the photovoltaic optimizer has a complex structure and is not easy to assemble.

In view of this, embodiments of this application provide a photovoltaic optimizer and a photovoltaic power generation system. A printed circuit board in the photovoltaic optimizer is disposed in an accommodation cavity formed by an end cover and a metal housing that is a hollow structure having an opening, and a cable is connected to the printed circuit board through a through hole on the end cover. In this way, in an operating process of the photovoltaic optimizer, heat generated by a device mounted on the printed circuit board is dissipated to the outside of the metal housing through the metal housing. Further, the photovoltaic optimizer not only can ensure good heat dissipation effect, but also has a simple structure and is easy to assemble. Correspondingly, costs of the photovoltaic power generation system are also low.

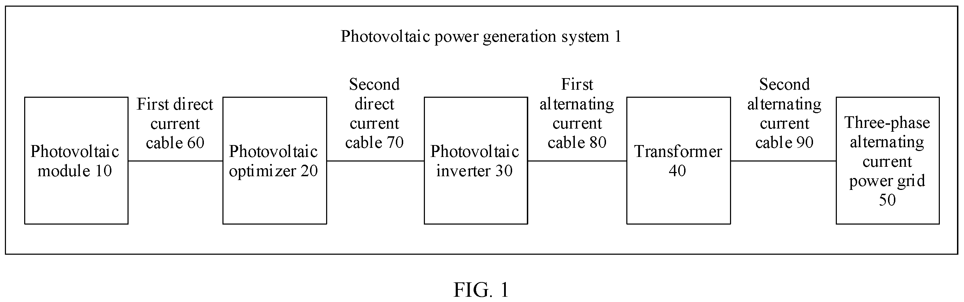

The following first describes in detail a photovoltaic power generation system provided in an embodiment of this application with reference to FIG. 1.

FIG. 1 is a schematic diagram of a photovoltaic power generation system according to an embodiment of this application.

As shown in FIG. 1, the photovoltaic power generation system 1 provided in this embodiment of this application includes one or more photovoltaic modules 10, one or more photovoltaic optimizers 20, a photovoltaic inverter 30, a transformer 40, a three-phase alternating current power grid 50, a first direct current cable 60, a second direct current cable 70, a first alternating current cable 80, and a second alternating current cable 90. The one or more photovoltaic modules 10 are connected to the photovoltaic optimizer 20 through the first direct current cable 60, and a connection relationship between the photovoltaic module 10 and the photovoltaic optimizer 20 may be a one-to-one connection. The one or more photovoltaic optimizers 20 are connected to the photovoltaic inverter 30 through the second direct current cable 70. The photovoltaic inverter 30 converts a direct current into an alternating current, and an alternating current side of the photovoltaic inverter 30 is connected to the transformer 40 through the first alternating current cable 80. The transformer 40 is connected to the three-phase alternating current power grid 50 through the second alternating current cable 90. In this way, an alternating current output by the photovoltaic inverter 30 flows into the three-phase alternating current power grid 50 after passing through the transformer 40. The following describes in detail the devices included in the photovoltaic power generation system 1.

The photovoltaic power generation system is a power generation system that converts solar radiation energy into electric energy based on photovoltaic effect of a semiconductor material. The photovoltaic power generation system provided in this embodiment of this application can energize an electric vehicle. The electric vehicle includes a pure electric vehicle (pure electric vehicle/battery electric vehicle, pure EV/battery EV), a hybrid electric vehicle (hybrid electric vehicle, HEV), a range extended electric vehicle (range extended electric vehicle, REEV), a plug-in hybrid electric vehicle (plug-in hybrid electric vehicle, PHEV), a new energy vehicle (new energy vehicle, NEV), or the like.

The photovoltaic module 10 may also be referred to as a photovoltaic array, and includes a plurality of photovoltaic (Photovoltaic, PV) strings (string). Each photovoltaic string includes a plurality of photovoltaic panels connected in series. The photovoltaic panel is configured to convert light energy into electric energy. The electric energy generated by the photovoltaic panel is a direct current (direct current, DC). A voltage at both ends of the photovoltaic string is equal to a sum of voltages generated by the plurality of photovoltaic panels. Output power of the photovoltaic module may represent electric energy output by the photovoltaic module per unit time.

The photovoltaic optimizer 20 may also be referred to as a photovoltaic power optimizer. The photovoltaic optimizer 20 may continuously track a maximum power point of each photovoltaic module 10 to increase an energy yield of the photovoltaic power generation system 1. The photovoltaic optimizer 20 has functions such as module-level shutdown and module-level monitoring, and supports maximum power point capture in a long string design scenario.

In an embodiment, the photovoltaic optimizer 20 includes a metal housing, a printed circuit board module, an end cover, and a cable. The metal housing is a hollow structure having an opening. The end cover is configured to cover the opening of the metal housing to form an accommodation cavity, the accommodation cavity is configured to accommodate the printed circuit board module, and the end cover includes at least one through hole. The printed circuit board module includes a printed circuit board. An end of the cable is connected to the printed circuit board through at least one through hole.

The photovoltaic inverter 30 is configured to convert an input direct current into an alternating current (alternating current, AC), that is, perform DC-AC conversion. The photovoltaic inverter 30 may also be referred to as a DC-AC converter.

The transformer 40 may be configured to perform voltage conversion on an alternating current, to adjust a voltage value of an input alternating current voltage. It should be understood that both an input and an input of the transformer 40 are alternating currents. The transformer 40 may boost an alternating current output by one or more photovoltaic inverters 30.

In the photovoltaic power generation system 1, an area of each photovoltaic module 10 is usually fixed, and when light intensity of a light ray remains unchanged, a larger included angle between a light ray irradiated onto the photovoltaic module 10 and a plane on which the photovoltaic module 10 is located, namely, a smaller incident angle of the light ray irradiated onto the photovoltaic module 10, indicates more electric energy output by the photovoltaic module 10. When a light ray is vertically irradiated onto the photovoltaic module 10, that is, when an included angle between the light ray and the plane on which the photovoltaic module 10 is located is 90°, which reaches a maximum value, output power of the photovoltaic module 10 reaches a maximum.

When the photovoltaic power generation system 1 includes a plurality of photovoltaic optimizers 20, the photovoltaic power generation system 1 further includes a combiner box. The combiner box is configured to: combine direct currents generated by the plurality of photovoltaic modules 10, and input a combined output to the photovoltaic inverter 30 after performing a circuit breaker processing and a lightning protection processing.

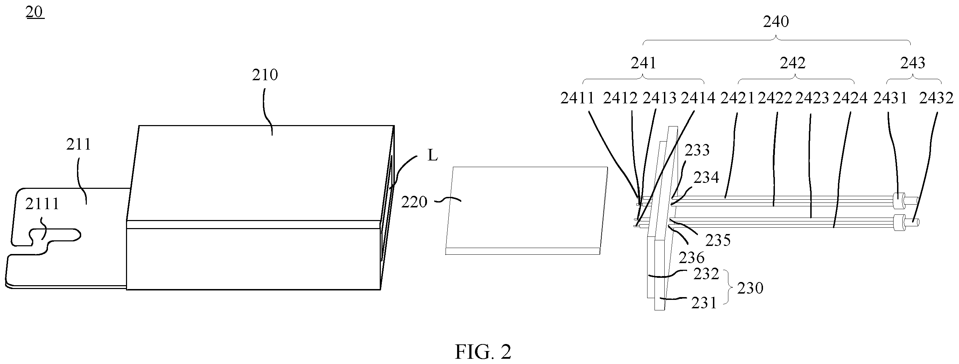

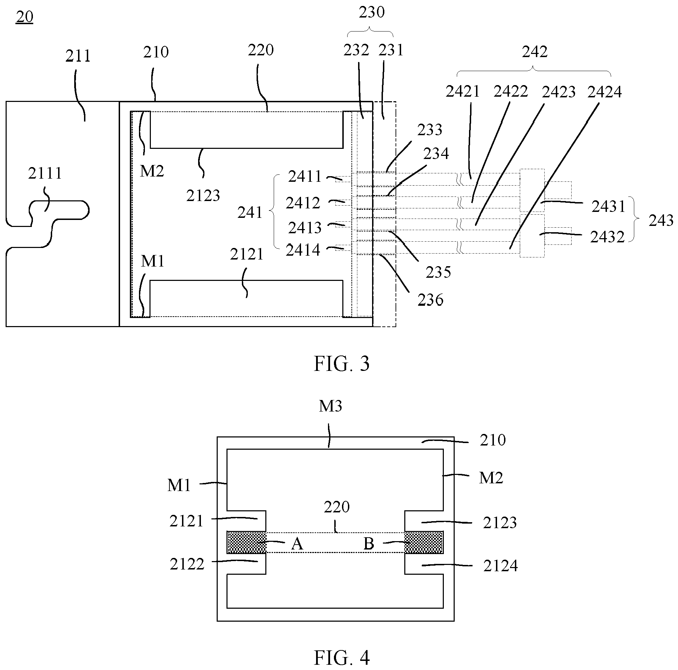

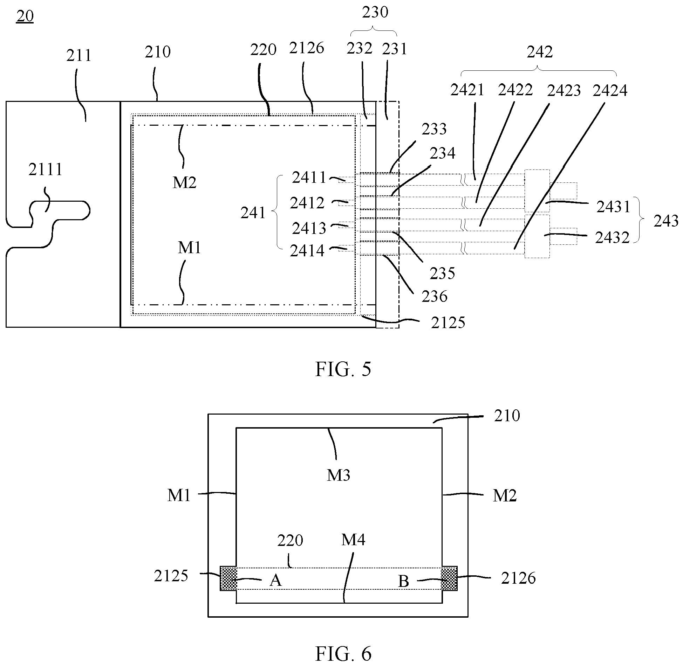

The photovoltaic optimizer 20 provided in embodiments of this application is described in detail below with reference to FIG. 2 to FIG. 6. FIG. 2 is an exploded view of a photovoltaic optimizer according to an embodiment of this application. FIG. 3 is a schematic diagram of an assembly of a photovoltaic optimizer according to an embodiment of this application. FIG. 4 is a schematic diagram of an assembly between a metal housing and a printed circuit board module in the photovoltaic optimizer shown in FIG. 3. FIG. 5 is a schematic diagram of an assembly of another photovoltaic optimizer according to an embodiment of this application. FIG. 6 is a schematic diagram of an assembly between a metal housing and a printed circuit board module in the photovoltaic optimizer shown in FIG. 5.

As shown in FIG. 2, FIG. 3, and FIG. 5, the photovoltaic optimizer 20 includes a metal housing 210, a printed circuit board module 220, an end cover 230, and a cable 240. The metal housing 210 is a hollow structure having an opening L. The end cover 230 is configured to cover the opening L of the metal housing 210 to form an accommodation cavity, and the accommodation cavity is configured to accommodate the printed circuit board module 220. The end cover 230 includes at least one through hole. The printed circuit board module 220 includes a printed circuit board and at least one device mounted on the printed circuit board. An input end 241 of the cable 240 is connected to the printed circuit board through the at least one through hole.

In this embodiment of this application, the printed circuit board module 220 in the photovoltaic optimizer 20 is disposed in an accommodation cavity formed by the end cover 230 and the metal housing 210 that is a hollow structure having the opening L, and the cable 240 is connected to the printed circuit board in the printed circuit board module 220 through the through hole on the end cover 230. In this way, in an operating process of the photovoltaic optimizer 20, heat generated by a device mounted on the printed circuit board is dissipated to the outside of the metal housing 210 through the metal housing 210. Further, the photovoltaic optimizer 20 not only can ensure good heat dissipation effect, but also has a simple structure and is easy to assemble. Correspondingly, costs of the photovoltaic power generation system 10 are also low.

In addition, the end cover 230 may further eliminate stress of the cable at the through hole, and prevent the cable at the through hole from being bent and damaged.

For example, the device mounted on the printed circuit board includes a programmable logic controller (programmable logic controller, PLC), a metal-oxide-semiconductor field-effect transistor (metal-oxide-semiconductor field-effect transistor, MOSFET) device, and the like.

In some embodiments, a limiting structure is disposed on an inner wall of the metal housing 210. The limiting structure cooperates with the printed circuit board module 220 to prevent the printed circuit board module 220 from moving in a direction parallel to the end cover 230.

In this embodiment of this application, the limiting structure is formed by a protrusion or a groove. The following describes the limiting structure in detail with reference to FIG. 4 and FIG. 6. Limiting structures in FIG. 3 and FIG. 4 are formed by protrusions, and limiting structures in FIG. 5 and FIG. 6 are formed by grooves.

As shown in FIG. 4, the limiting structure includes a first protrusion 2121 and a second protrusion 2122 that protrude from a first inner wall M1 of the metal housing 210 to a second inner wall M2 of the metal housing 210, and a third protrusion 2123 and a fourth protrusion 2124 that protrude from the second inner wall M2 of the metal housing 210 to the first inner wall M1 of the metal housing 210. A first part A of the printed circuit board module 220 is accommodated between the first protrusion 2121 and the second protrusion 2122, and the second part B of the printed circuit board module 220 is accommodated between the third protrusion 2123 and the fourth protrusion 2124. In addition, a distance between a wall that is of the first protrusion 2121 and that is close to the second protrusion 2122 and a wall that is of the second protrusion 2122 and that is close to the first protrusion 2121 is equal to a size that is of the first part A of the printed circuit board module 220 and that is in a direction perpendicular to a third inner wall M3 of the metal housing 210. A distance between a wall that is of the third protrusion 2123 and that is close to the fourth protrusion 2124 and a wall that is of the fourth protrusion 2124 and that is close to the third protrusion 2123 is equal to a size that is of the second part B of the printed circuit board module 220 and that is in a direction perpendicular to the third inner wall M3 of the metal housing 210. The first inner wall M1 of the metal housing 210 and the second inner wall M2 of the metal housing 210 are arranged opposite to each other, and the third inner wall M3 of the metal housing 210 is perpendicular to both the end cover 230 and the first inner wall M1 of the metal housing 210.

Correspondingly, along the opening L of the metal housing 210, a gap between the first protrusion 2121 and the second protrusion 2122, and a gap between the third protrusion 2123 and the fourth protrusion 2124, the printed circuit board module 220 may be disposed in space formed by the first protrusion 2121, the second protrusion 2122, the third protrusion 2123, and the fourth protrusion 2124 of the metal housing 210.

In this example, the first protrusion 2121, the second protrusion 2122, the third protrusion 2123, and the fourth protrusion 2124 in the inner wall of the metal housing 210 cooperate with the printed circuit board module 220 separately, to limit movement of the printed circuit board module 220 in a direction perpendicular to the third inner wall M3.

Further, in some embodiments, as shown in FIG. 3 and FIG. 4, a size that is of the printed circuit board module 220 and that is in a direction perpendicular to the first inner wall M1 of the metal housing 210 is equal to a distance between the first inner wall M1 of the metal housing 210 and the second inner wall M2 of the metal housing 210. In addition, as shown in FIG. 4, a distance between the first protrusion 2121 and the third inner wall M3 of the metal housing 210 is equal to a distance between the third protrusion 2123 and the third inner wall M3 of the metal housing 210. A distance between the second protrusion 2122 and the third inner wall M3 of the metal housing 210 is equal to a distance between the fourth protrusion 2124 and the third inner wall M3 of the metal housing 210. Correspondingly, the first inner wall M1 and the second inner wall M2 of the metal housing 210 may limit movement of the printed circuit board module 220 in a direction perpendicular to the first inner wall M1 of the metal housing 210.

As shown in FIG. 6, the limiting structure includes a first groove 2125 that is recessed, in a direction away form a second inner wall M2 of the metal housing 210, from a first inner wall M1 of the metal housing 210, and a second groove 2126 that is recessed, in a direction away from the first inner wall M1 of the metal housing 210, from the second inner wall M2 of the metal housing 210. A first part A of the printed circuit board module 220 is accommodated in the first groove 2125, and a second part B of the printed circuit board module 220 is accommodated in the second groove 2126. In addition, a size that is of the first groove 2125 and that is in a direction perpendicular to a third inner wall M3 of the metal housing 210 is equal to a size that is of the first part A of the printed circuit board module 220 and that is in a direction perpendicular to the third inner wall M3. A size that is of the second groove 2126 and that is in a direction perpendicular to the third inner wall M3 of the metal housing 210 is equal to a size that is of the second part B of the printed circuit board module 220 and that is in a direction perpendicular to the third inner wall M3. The second inner wall M2 of the metal housing 210 and the first inner wall M1 of the metal housing 210 are arranged opposite to each other. The third inner wall M3 of the metal housing 210 is perpendicular to both the end cover 230 and the first inner wall M1 of the metal housing 210.

In this example, the first groove 2125 and the second groove 2126 cooperate with the printed circuit board module 220 separately, to limit movement of the printed circuit board module 220 in a direction perpendicular to the third inner wall M3.

The first groove 2125 has two connected openings, a direction of one opening of the first groove 2125 is the same as a direction of the opening L of the metal housing 210, and a direction of the other opening of the first groove 2125 is perpendicular to the first inner wall M1 of the metal housing 210. In addition, the second groove 2126 also has two openings, a direction of one opening of the second groove 2126 is the same as a direction of the opening L of the metal housing 210, and a direction of the other opening of the second groove 2126 is perpendicular to the first inner wall M1 of the metal housing 210. Correspondingly, along the opening L of the metal housing 210, an opening that is of the first groove 2125 and that is in a direction perpendicular to the first inner wall M1 of the metal housing 210, and an opening that is of the second groove 2126 and that is in a direction perpendicular to the first inner wall M1 of the metal housing 210, the printed circuit board module 220 may be disposed in the first groove 2125 and the second groove 2126 of the metal housing 210.

In an embodiment, as shown in FIG. 6, neither of two walls that are of the first groove 2125 and the second groove 2126 and that are arranged opposite to each other in a direction perpendicular to the third inner wall M3 is flush with the third inner wall M3 of the metal housing 210 or the fourth inner wall M4 of the metal housing 210. In an embodiment, one of two walls that are of the first groove 2125 and the second groove 2126 and that are arranged opposite to each other in a direction perpendicular to the third inner wall M3 is flush with the fourth inner wall M4 of the metal housing 210. In an embodiment, one of two walls that are of the first groove 2125 and the second groove 2126 and that are arranged opposite to each other in a direction perpendicular to the third inner wall M3 is flush with the third inner wall M3 of the metal housing 210.

Further, in some embodiments, as shown in FIG. 5 and FIG. 6, a size that is of the printed circuit board module 220 and that is in a direction perpendicular to the first inner wall M1 of the metal housing 210 is equal to a distance between a wall that is of the first groove 2125 and that is farthest from the second groove 2126 and a wall that is of the second groove 2126 and that is farthest from the first groove 2125. In addition, a distance between the first groove 2125 and the third inner wall M3 of the metal housing 210 is equal to a distance between the second groove 2126 and the third inner wall M3 of the metal housing 210. Correspondingly, the first groove 2125 and the second groove 2126 may limit movement of the printed circuit board module 220 in a direction perpendicular to the first inner wall M1 of the metal housing 210.

It should be understood that the distance between the first groove 2125 and the third inner wall M3 of the metal housing 210 may be understood as a distance between the third inner wall M3 and a wall that is of the first groove 2125 and that is parallel to the third inner wall M3. Similarly, the distance between the second groove 2126 and the third inner wall M3 of the metal housing 210 may be understood as a distance between the third inner wall M3 and a wall that is of the second groove 2126 and that is parallel to the third inner wall M3. The wall that is of the first groove 2125 and that is parallel to the third inner wall M3 is flush with the wall that is of the second groove 2126 and that is parallel to the third inner wall M3.

In some embodiments, the photovoltaic optimizer 20 further includes a first potting glue, and the first potting glue is configured to fill a gap between the inner wall of the metal housing 210 and the printed circuit board module 220. Correspondingly, the first potting glue may seal the printed circuit board module 220 in the metal housing 210, so that the printed circuit board module 220 is isolated, and an objective of insulation of the printed circuit board module 220 is achieved. In addition, the first potting glue may further transfer heat generated by a device on the printed circuit board to the metal housing 210, and then the heat is transferred to surrounding air outside the metal housing 210, so that a heat dissipation capability of the photovoltaic optimizer 20 is enhanced.

In this embodiment, the metal housing 210 further includes a potting hole and a potting plug. A gap between the inner wall of the metal housing 210 and the printed circuit board module 220 is filled with the first potting glue through the potting hole. After the first potting glue is formed, the potting plug is plugged into the potting hole, so that the accommodation cavity formed by the metal housing 210 and the end cover 230 is sealed.

In an embodiment, as shown in FIG. 2, FIG. 3, and FIG. 5, the end cover 230 includes a cover plate 231 and a protrusion portion 232 protruding on the cover plate 231. An outer ring surface of the protrusion portion 232 is in contact with the inner wall of the metal housing 210, and the cover plate 231 covers the opening L of the metal housing 210. Correspondingly, the protrusion portion 232 extends into the hollow structure of the metal housing 210 from the opening L side of the metal housing 210, and the outer ring surface of the protrusion portion 232 is in contact with the inner wall of the metal housing 210. Therefore, the protrusion portion 232 cooperates with the inner wall of the metal housing 210, and the end cover 230 covers the opening L of the metal housing 210 to form the accommodation cavity.

In this embodiment, a sum of a size that is of the printed circuit board module 220 and that is in a direction perpendicular to the first inner wall M1 and the third inner wall M3 and a size that is of the protrusion portion 232 and that is in a direction perpendicular to the first inner wall M1 and the third inner wall M3 is equal to a size that is of the accommodation cavity and that is in a direction perpendicular to the first inner wall M1 and the third inner wall M3. In some embodiments, the photovoltaic optimizer 20 further includes a connection structure, and the connection structure is configured to fasten the end cover 230 and the metal housing 210.

In an embodiment, the connection structure includes a colloid. Specifically, the colloid is disposed on a surface on which the cover plate 231 of the end cover 230 is in contact with the metal housing 210 and/or a surface on which the outer ring surface of the protrusion portion 232 of the end cover 230 is in contact with the metal housing 210.

For example, the colloid is a gel formed through a gel process. For another example, the colloid is a curing adhesive formed through a curing process.

In an embodiment, the connection structure includes a screw. The screw passes through the cover plate 231, a surface that is of the cover plate 231 and that is in contact with the metal housing 210, and a wall that is of the metal housing 210 and that has an opening, to implement a fixed connection between the end cover 230 and the metal housing 210. The screw is a self-locking screw.

In some embodiments, the metal housing 210 further includes a first side arm and a second side arm. The first side arm extends, along an outer wall corresponding to the first inner wall M1 of the metal housing 210, to a side that is away from the second inner wall M2 of the metal housing 210, and the first side arm extends, along an outer wall corresponding to the second inner wall M of the metal housing 210, to a side that is away from the first inner wall M1 of the metal housing 210. In an embodiment, the connection structure includes only a screw, and the screw is a self-locking screw. Specifically, the screw passes through the cover plate 231, a surface that is of the first side arm and that is in contact with the cover plate 231, and a surface that is of the second side arm and that is in contact with the cover plate 231, to implement a fixed connection between the end cover 230 and the metal housing 210. In an embodiment, in addition to the screw, the connection structure further includes a nut. One screw passes through the cover plate 231, the first side arm cooperates with one nut, the other screw passes through the cover plate 231, and the second side arm cooperates with the other nut, to implement a fixed connection between the end cover 230 and the metal housing 210.

In an embodiment, the end cover 230 includes only the cover plate 231 shown in FIG. 2, FIG. 3, and FIG. 5, and is attached to one side of the opening of the metal housing 210. In addition, in this embodiment, the photovoltaic optimizer 20 includes the connection structure described above. For descriptions of the connection structure, refer to the foregoing related descriptions. Details are not described herein again.

In this embodiment, a size that is of the printed circuit board module 220 and that is in a direction perpendicular to the first inner wall M1 and the third inner wall M3 is equal to a size that is of the accommodation cavity and that is in a direction perpendicular to the first inner wall M1 and the third inner wall M3.

As shown in FIG. 2, FIG. 3, and FIG. 5, the cable 240 includes an input end 241, a conducting wire 242, and an output end 243. As shown in FIG. 1, one end of the photovoltaic optimizer 20 is connected to the photovoltaic module 10, and the other end is connected to the photovoltaic inverter 30. Therefore, as shown in FIG. 2, FIG. 3, and FIG. 5, the output end 243 of the cable 240 of the photovoltaic optimizer 20 includes a first output end 2431 and a second output end 2432. The first output end 2431 corresponds to a first conducting wire 2421 and a second conducting wire 2422, and the second output end 2432 corresponds to a third wire 2423 and a fourth wire 2424. In addition, the first output end 2431 corresponds to the first input end 2411 and the second input end 2412. One of the first input end 2411 and the second input end 2412 is configured to connect to a positive electrode on the printed circuit board in the printed circuit board module 220, and the other is configured to connect to a negative electrode on the printed circuit board in the printed circuit board module 220. The second output end 2432 corresponds to the third input end 2413 and the fourth input end 2414. One of the third input end 2413 and the fourth input end 2414 is configured to connect to a positive electrode on the printed circuit board in the printed circuit board module 220, and the other is configured to connect to a negative electrode on the printed circuit board in the printed circuit board module 220.

Further, the end cover 230 includes four through holes: a first through hole 233, a second through hole 234, a third through hole 235, and a fourth through hole 236 shown in FIG. 2, FIG. 3, and FIG. 5. The first input end 2411 passes through the first through hole 233 and is connected to the printed circuit board in the printed circuit board module 220. The second input end 2412 passes through the second through hole 234 and is connected to the printed circuit board in the printed circuit board module 220. The third input end 2413 passes through the third through hole 235 and is connected to the printed circuit board in the printed circuit board module 220. The fourth input end 2414 passes through the fourth through hole 236 and is connected to the printed circuit board in the printed circuit board module 220. The first output end 2431 extends out of the metal housing 210 to form a connector of the photovoltaic optimizer 20. The second output end 2432 extends out of the metal housing 210 to form another connector of the photovoltaic optimizer 20. One of the two connectors is connected to the photovoltaic module 10, and the other connector is connected to the photovoltaic inverter 30.

It should be noted that the input end 24 of the cable 240 is an end that is of the cable 240 and that is connected to an interior of the photovoltaic optimizer 20. The output end 243 of the cable 240 is an end that is of the cable 240 and that is connected to another component in the photovoltaic power generation system. For example, the another component includes the photovoltaic module 10 and the photovoltaic inverter 30 shown in FIG. 1.

In some embodiments, the photovoltaic optimizer 20 further includes a second potting glue, and the second potting glue is configured to fill a gap between the at least one through hole and the cable 240. Correspondingly, the accommodation cavity formed by the end cover 230 covering the opening L of the metal housing 210 is a sealed accommodation cavity, so that the printed circuit board module 220 accommodated in the accommodation cavity can be waterproofed and sealed.

In some embodiments, the photovoltaic optimizer 20 further includes a thermally conductive insulation film, and the thermally conductive insulation film is disposed on the inner wall of the metal housing 210. Correspondingly, the thermally conductive insulation film may transfer heat generated by the printed circuit board module 220 to the metal housing 210, and then the heat is transferred to surrounding air outside the metal housing 210, so that a heat dissipation capability of the photovoltaic optimizer 20 is enhanced.

In some embodiments, as shown in FIG. 2, FIG. 3, and FIG. 5, the photovoltaic optimizer 20 further includes a mounting ear structure 211. The mounting ear structure 211 is fastened to the metal housing 210. The mounting ear structure 211 includes at least one mounting hole 2111, and the at least one mounting hole 2111 is configured to mount the photovoltaic optimizer 20 to a target structure.

For example, the target structure includes a support of the photovoltaic module 10 and the like.

In an embodiment, the mounting ear structure 211 and the metal housing 210 are of an integrated structure. Correspondingly, assembly procedures of the photovoltaic optimizer 20 may be reduced.

In this embodiment of this application, the metal housing 210 and the mounting ear structure 211 are of an integrated structure generated through an integrated molding process. Correspondingly, by using the metal housing 210, the photovoltaic optimizer 20 can not only implement heat dissipation of the photovoltaic optimizer 20, but can also be mounted on the target structure.

In an embodiment, the metal housing 210 is made of a metal material through sheet metal molding and welding. In an embodiment, the metal housing 210 is made of a metal material through profile forming and cutting.

In an embodiment, the mounting ear structure 211 and the metal housing 210 are two separate structures. Correspondingly, the mounting ear structure 211 and the metal housing 210 may be easily processed.

In some embodiments, the mounting ear structure 211 is disposed on an outer wall that is of the metal housing 210 and that is opposite to the opening L of the metal housing 210.

In some embodiments, the mounting ear structure 211 is a sheet-like structure.

In some embodiments, the metal housing 210 may be alternatively replaced with a non-metal housing.

In an embodiment, a thermal conductivity of a material used by the non-metal housing is greater than or equal to a thermal conductivity of a metal material. For example, a material used by the non-metal housing includes a polycarbonate material PC plastic. For example, the non-metal housing may be formed through an injection molding process.

It should be understood that different metal materials have different thermal conductivities. In addition, that the thermal conductivity of the material used by the non-metal housing is greater than or equal to the thermal conductivity of the metal material may be understood as: the thermal conductivity of the material used by the non-metal housing is greater than or equal to a thermal conductivity of a metal material with a lowest thermal conductivity.

In an embodiment, a thermal conductivity of the used non-metal housing satisfies heat dissipation requirements of the photovoltaic optimizer 20. It should be understood that the heat dissipation requirements of the photovoltaic optimizer 20 also vary in different operating conditions.

In this embodiment of this application, the printed circuit board module 220 may also be referred to as a printed circuit board assembly (printed circuit board assembly, PCBA).

In some embodiments, in addition to the printed circuit board and the at least one device mounted on the printed circuit board, the printed circuit board module 220 further has a bearing frame. The bearing frame is configured to bear the printed circuit board module 220, so that the printed circuit board module 220 is not in direct contact with the metal housing 210.

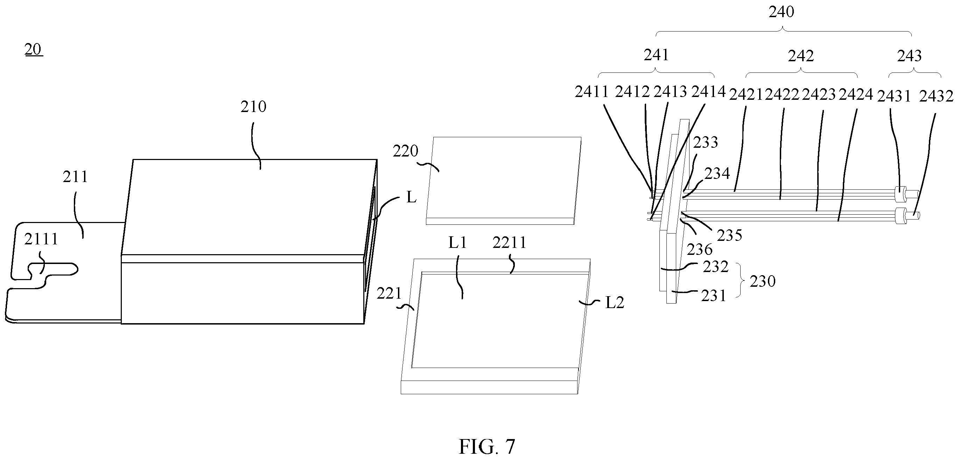

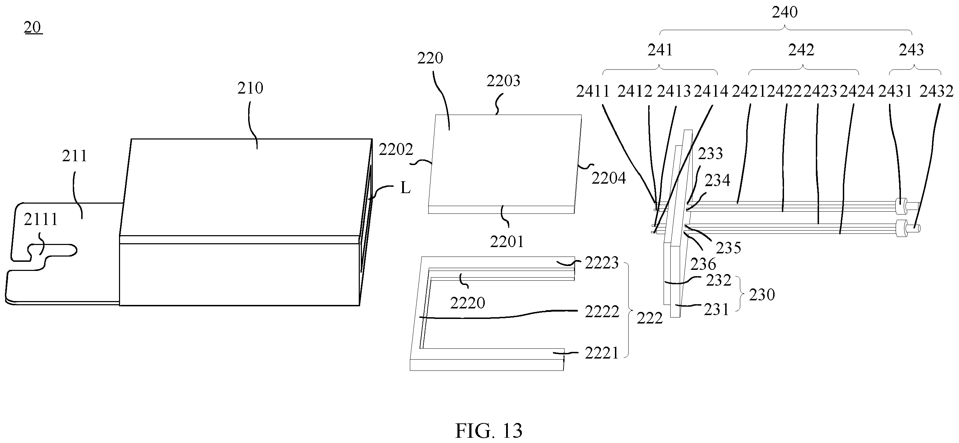

FIG. 7 to FIG. 16 are photovoltaic optimizers with a bearing frame. A support 221 shown in FIG. 7 to FIG. 12 is an example of the bearing frame. The outer frame 222 shown in FIG. 13 to FIG. 16 is another example of the bearing frame.

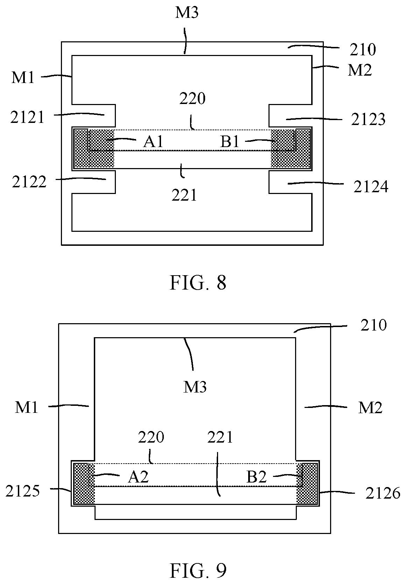

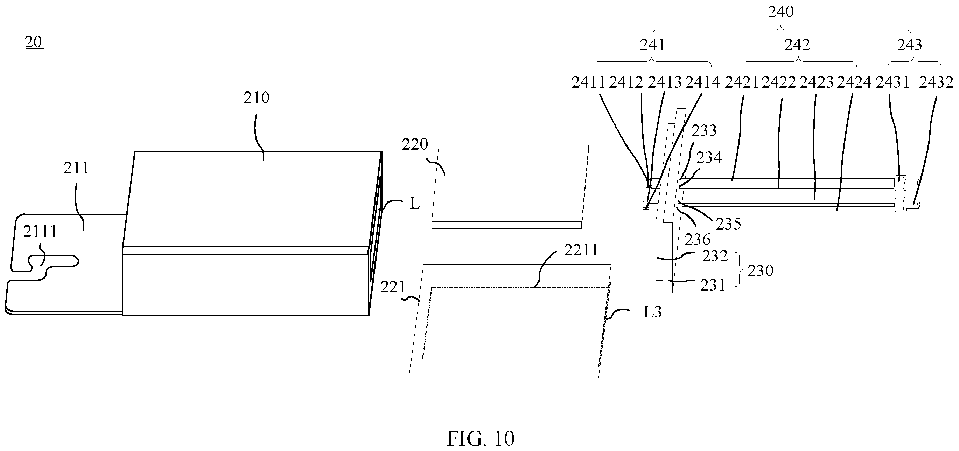

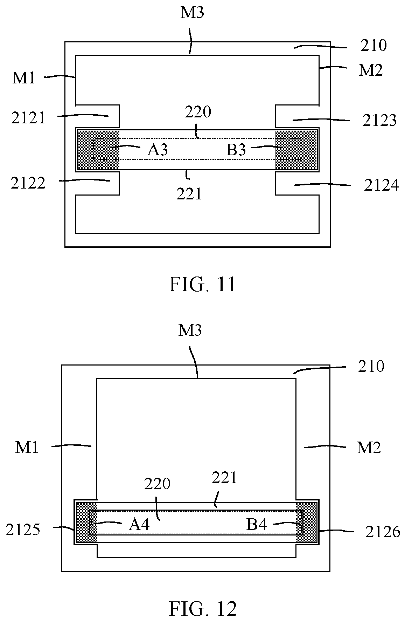

The following describes the support 221 in detail with reference to FIG. 7 to FIG. 12. FIG. 7 is an exploded view of a photovoltaic optimizer according to an embodiment of this application. FIG. 8 is a schematic diagram of an assembly between a metal housing 210 and a printed circuit board module 220 having a support in the photovoltaic optimizer shown in FIG. 7. FIG. 9 is a schematic diagram of another assembly between a metal housing 210 and a printed circuit board module 220 having a support in the photovoltaic optimizer shown in FIG. 7. FIG. 10 is an exploded view of another photovoltaic optimizer according to an embodiment of this application. FIG. 11 is a schematic diagram of an assembly between a metal housing 210 and a printed circuit board module 220 having a support in the photovoltaic optimizer shown in FIG. 10. FIG. 12 is a schematic diagram of another assembly between a metal housing 210 and a printed circuit board module 220 having a support in the photovoltaic optimizer shown in FIG. 10.

As shown in FIG. 7 to FIG. 12, the printed circuit board module 220 has a support 221. An accommodation groove 2211 that is recessed toward an interior of the support 221 is disposed on the support 221, and the accommodation groove 2211 is configured to bear the printed circuit board module 220.

Correspondingly, the printed circuit board module 220 is borne in the support 221, and problems such as EMC of the photovoltaic optimizer 20 can be resolved. In addition, a creepage distance of the printed circuit board module 220 can be increased, so that the photovoltaic optimizer 20 can better satisfy safety requirements.

In some embodiments, a material used by the support 221 is a thermally conductive insulation material.

In an embodiment, as shown in FIG. 7, the support 221 is a structure formed after a hexahedral structure is recessed from a large face of the hexahedral structure toward an interior of the support 221. Correspondingly, the accommodation groove 2211 is recessed from the large face of the support 221 toward the interior of the support 221. In addition, the accommodation groove 2211 wraps four or five faces of the support 221.

It should be understood that a large face of a structure in embodiments of this application may be understood as a face with a largest area in the structure.

In some embodiments, as shown in FIG. 7, the accommodation groove 2211 has an opening L1 and an opening L2 that are in communication with each other. A direction of the opening L1 is perpendicular to the large face of the support 221, and a direction of the opening L2 is perpendicular to the direction of the opening L1. Correspondingly, the printed circuit board module 220 may be mounted in the accommodation groove 2211 along the opening L1 of the accommodation groove 2211. The input end 241 of the cable 240 is connected to the printed circuit board in the printed circuit board module 220 along the opening L2 of the accommodation groove 2211.

It should be noted that in the photovoltaic optimizer 20 shown in FIG. 7, if the limiting structure includes the first protrusion 2121, the second protrusion 2122, the third protrusion 2123, and the fourth protrusion 2124, the first part A that is of the printed circuit board module 220 and that is accommodated between the first protrusion 2121 and the second protrusion 2122 described above is a first part A1 of the printed circuit board module 220 having the support 221 shown in FIG. 8, and the second part B that is of the printed circuit board module 220 and that is accommodated between the third protrusion 2123 and the fourth protrusion 2124 is a second part Bl of the printed circuit board module 220 having the support 221 shown in FIG. 8.

In addition, if the limiting structure includes the first groove 2125 and the second groove 2126, the first part A that is of the printed circuit board module 220 and that is accommodated in the first groove 2125 described above is a first part A2 of the printed circuit board module 220 having the support 221 shown in FIG. 9, and the second part B that is of the printed circuit board module 220 and that is accommodated in the second groove 2126 is a second part B2 of the printed circuit board module 220 having the support 221 shown in FIG. 9.

In an embodiment, as shown in FIG. 10, the support 221 is a structure formed after a hexahedral structure is recessed from a small face of the hexahedral structure toward the interior of the support 221. Correspondingly, the accommodation groove 2211 is recessed from the small face of the support 221 toward the interior of the support 221. In addition, the accommodation groove 2211 wraps five faces of the support 221.

It should be understood that a small face of a structure in embodiments of this application may be understood as a face with a smallest area in the structure.

In some embodiments, as shown in FIG. 10, the accommodation groove 2211 has an opening L3, and a direction of the opening L3 is perpendicular to the small face of the support 221. Correspondingly, one end that is of the printed circuit board module 220 and that is not connected to the cable 240 may be mounted in the accommodation groove 2211 along the opening L3 of the accommodation groove 2211.

It should be noted that in the photovoltaic optimizer 20 shown in FIG. 8, if the limiting structure includes the first protrusion 2121, the second protrusion 2122, the third protrusion 2123, and the fourth protrusion 2124, the first part A that is of the printed circuit board module 220 and that is accommodated between the first protrusion 2121 and the second protrusion 2122 described above is a first part A3 of the printed circuit board module 220 having the support 221 shown in FIG. 11, and the second part B that is of the printed circuit board module 220 and that is accommodated between the third protrusion 2123 and the fourth protrusion 2124 is a second part B3 of the printed circuit board module 220 having the support 221 shown in FIG. 11.

In addition, if the limiting structure includes the first groove 2125 and the second groove 2126, the first part A that is of the printed circuit board module 220 and that is accommodated in the first groove 2125 described above is a first part A4 of the printed circuit board module 220 having the support 221 shown in FIG. 12, and the second part B that is of the printed circuit board module 220 and that is accommodated in the second groove 2126 is a second part B4 of the printed circuit board module 220 having the support 221 shown in FIG. 12.

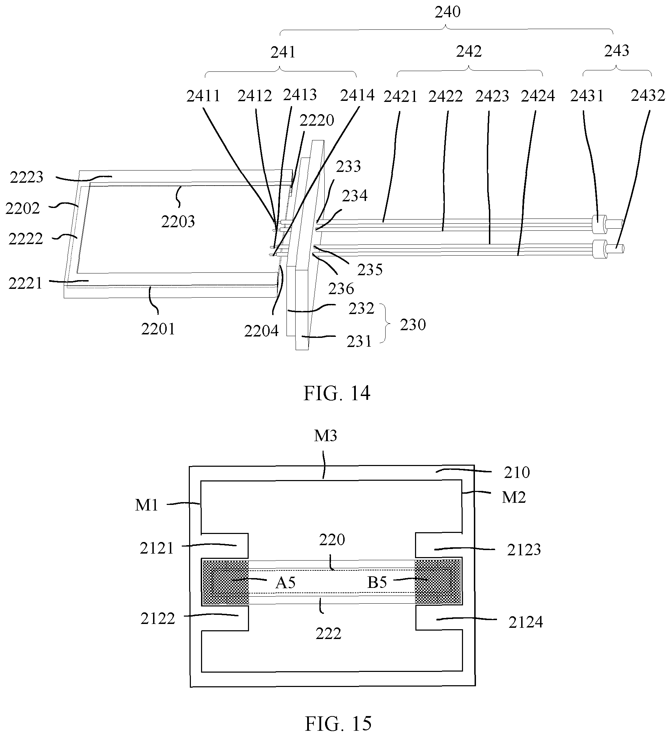

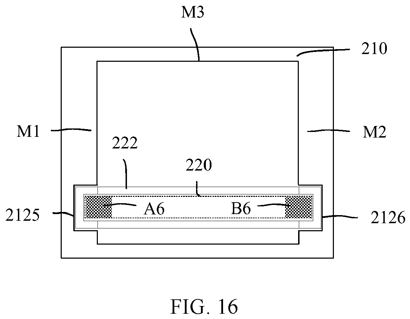

The following describes the outer frame in detail with reference to FIG. 13 and FIG. 16. FIG. 13 is an exploded view of a photovoltaic optimizer according to an embodiment of this application. FIG. 14 is a schematic diagram of an assembly between a printed circuit board module 220 having an outer frame 222 and a cable 240 in the photovoltaic optimizer shown in FIG. 13. FIG. 15 is a schematic diagram of an assembly between a printed circuit board module 220 having an outer frame 222 and a metal housing 210 in the photovoltaic optimizer shown in FIG. 13. FIG. 16 is a schematic diagram of another assembly between a printed circuit board module 220 having an outer frame 222 and a metal housing 210 in the photovoltaic optimizer shown in FIG. 13.

As shown in FIG. 13, an outer frame 222 is wrapped around an edge that is of the printed circuit board module 220 and that is not connected to the cable 240. The outer frame 222 has a bearing channel 2220 that runs through the outer frame 222, and the bearing channel 2220 is configured to bear the printed circuit board module 220.

Correspondingly, an edge of the printed circuit board module 220 is wrapped by the outer frame 222, so that the problem of the EMC of the photovoltaic optimizer 20 can be resolved. In addition, a creepage distance of the printed circuit board module 220 can be increased, so that the photovoltaic optimizer 20 can better satisfy safety requirements.

As shown in FIG. 13 and FIG. 14, the printed circuit board module 220 includes a first edge 2201, a second edge 2202, a third edge 2203, and a fourth edge 2204 that are sequentially connected. The first edge 2201 and the third edge 2203 are arranged opposite to each other, and the second edge 2202 and the fourth edge 2204 are arranged opposite to each other. The outer frame 222 includes a first outer frame 2221, a second outer frame 2222, and a third outer frame 2223 that are sequentially connected. The first outer frame 2221 and the third outer frame 2223 are arranged opposite to each other, the first outer frame 2221. The second outer frame 2222, and the third outer frame 2223 each have a bearing channel, and bearing channels of the first outer frame 2221, the second outer frame 2222, and the third outer frame 2223 are in communication with each other to form a bearing channel 2220 of the outer frame 222.

In addition, as shown in FIG. 14, the first edge 2201 of the printed circuit board module 220 is borne in a bearing channel of the first outer frame 2221, the second edge 2202 of the printed circuit board module 220 is borne in a bearing channel of the second outer frame 2222, the third edge 2203 of the printed circuit board module 220 is borne in a bearing channel of the third outer frame 2223, and the fourth edge 2204 of the printed circuit board module 220 is connected to the cable 240.

In some embodiments, a material used by the outer frame 222 is a thermally conductive insulation material.

It should be noted that in the photovoltaic optimizer 20 shown in FIG. 13, if the limiting structure includes the first protrusion 2121, the second protrusion 2122, the third protrusion 2123, and the fourth protrusion 2124, the first part A that is of the printed circuit board module 220 and that is accommodated between the first protrusion 2121 and the second protrusion 2122 described above is a first part A5 of the printed circuit board module 220 having the outer frame 222 shown in FIG. 15, and the second part B that is of the printed circuit board module 220 and that is accommodated between the third protrusion 2123 and the fourth protrusion 2124 is a second part B5 of the printed circuit board module 220 having the outer frame 222 shown in FIG. 15.

In addition, if the limiting structure includes the first groove 2125 and the second groove 2126, the first part A of the printed circuit board module 220 accommodated in the first groove 2125 described above is a first part A6 of the printed circuit board module 220 having the outer frame 222 shown in FIG. 16, and the second part B of the printed circuit board module 220 accommodated in the second groove 2126 is a second part B6 of the printed circuit board module 220 having the outer frame 222 shown in FIG. 16.

In an embodiment, an assembly sequence of the photovoltaic optimizer 20 is: the input end 241 of the cable 240 with the end cover 230 is welded to a printed circuit board on which at least one device is mounted on the printed circuit board module 220. Then, along the opening L of the metal housing 210, the printed circuit board module 220 is inserted into the metal housing 210, and the end cover 230 covers the opening L of the metal housing 210.

In addition, if the printed circuit board module 220 of the photovoltaic optimizer 20 has a bearing frame, before the printed circuit board module 220 is inserted into the metal housing 210, the printed circuit board module 220 may be first placed in the bearing frame. Then, along the opening L of the metal housing 210, the bearing frame on which the printed circuit board module 220 is mounted is inserted into the metal housing 210, and the end cover 230 covers the opening L of the metal housing 210.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A photovoltaic optimizer, comprising a metal housing, a printed circuit board module, an end cover, and a cable, wherein
the metal housing is a hollow structure having an opening;
the end cover is configured to cover the opening of the metal housing to form an accommodation cavity, the accommodation cavity is configured to accommodate the printed circuit board module, and the end cover comprises at least one through hole;
the printed circuit board module comprises a printed circuit board and at least one device mounted on the printed circuit board; and
an input end of the cable is connected to the printed circuit board through the at least one through hole.

2. The photovoltaic optimizer according to claim 1, wherein a limiting structure is disposed on an inner wall of the metal housing, and the limiting structure cooperates with the printed circuit board module to prevent the printed circuit board module from moving in a direction parallel to the end cover

3. The photovoltaic optimizer according to claim 2, wherein
the limiting structure comprises a first protrusion and a second protrusion that protrude from a first inner wall of the metal housing to a second inner wall of the metal housing, and a third protrusion and a fourth protrusion that protrude from the second inner wall of the metal housing to the first inner wall of the metal housing, and the first inner wall of the metal housing and the second inner wall of the metal housing are arranged opposite to each other;
a first part of the printed circuit board module is accommodated between the first protrusion and the second protrusion, and a second part of the printed circuit board module is accommodated between the third protrusion and the fourth protrusion; and
a distance between a wall that is of the first protrusion and that is close to the second protrusion and a wall that is of the second protrusion and that is close to the first protrusion is equal to a size that is of the first part of the printed circuit board module and that is in a direction perpendicular to a third inner wall of the metal housing; and a distance between a wall that is of the third protrusion and that is close to the fourth protrusion and a wall that is of the fourth protrusion and that is close to the third protrusion is equal to a size that is of the second part of the printed circuit board module and that is in a direction perpendicular to the third inner wall of the metal housing, and the third inner wall of the metal housing is perpendicular to both the end cover and the first inner wall of the metal housing.

4. The photovoltaic optimizer according to claim 3, wherein a size that is of the printed circuit board module and that is in a direction perpendicular to the first inner wall of the metal housing is equal to a distance between the first inner wall of the metal housing and the second inner wall of the metal housing;
a distance between the first protrusion and the third inner wall of the metal housing is equal to a distance between the third protrusion and the third inner wall of the metal housing; and
a distance between the second protrusion and the third inner wall of the metal housing is equal to a distance between the fourth protrusion and the third inner wall of the metal housing.

5. The photovoltaic optimizer according to claim 2, wherein
the limiting structure comprises a first groove that is recessed, in a direction away from a second inner wall of the metal housing, from a first inner wall of the metal housing, and a second groove that is recessed, in a direction away from the first inner wall of the metal housing, from the second inner wall of the metal housing, and the second inner wall of the metal housing and the first inner wall of the metal housing are arranged opposite to each other;
a first part of the printed circuit board module is accommodated in the first groove, and a second part of the printed circuit board module is accommodated in the second groove; and
a size that is of the first groove and that is in a direction perpendicular to a third inner wall of the metal housing is equal to a size that is of the first part of the printed circuit board module and that is in a direction perpendicular to the third inner wall, a size that is of the second groove and that is in a direction perpendicular to the third inner wall of the metal housing is equal to a size that is of the second part of the printed circuit board module and that is in a direction perpendicular to the third inner wall, and the third inner wall of the metal housing is perpendicular to both the end cover and the first inner wall of the metal housing.

6. The photovoltaic optimizer according to claim 5, wherein a size that is of the printed circuit board module and that is in a direction perpendicular to the first inner wall of the metal housing is equal to a distance between a wall that is of the first groove and that is farthest from the second groove and a wall that is of the second groove and that is farthest from the first groove; and
a distance between the first groove and the third inner wall of the metal housing is equal to a distance between the second groove and the third inner wall of the metal housing.

7. The photovoltaic optimizer according to any one of claims 1 to 6, wherein
the printed circuit board module has a support, an accommodation groove that is recessed toward an interior of the support is disposed on the support, and the accommodation groove is configured to bear the printed circuit board module; or
an outer frame is wrapped around an edge that is of the printed circuit board module and that is not connected to the cable, the outer frame has a bearing channel that runs through the outer frame, and the bearing channel is configured to bear the printed circuit board module.

8. The photovoltaic optimizer according to claim 7, wherein
a material used by the support or the outer frame is a thermally conductive insulation material.

9. The photovoltaic optimizer according to any one of claims 1 to 8, wherein
the photovoltaic optimizer further comprises a first potting glue, and the first potting glue is configured to fill a gap between the inner wall of the metal housing and the printed circuit board module.

10. The photovoltaic optimizer according to any one of claims 1 to 9, wherein
the photovoltaic optimizer further comprises a second potting glue, and the second potting glue is configured to fill a gap between the at least one through hole and the cable.

11. The photovoltaic optimizer according to any one of claims 1 to 10, wherein
the photovoltaic optimizer further comprises a thermally conductive insulation film, and the thermally conductive insulation film is disposed on the inner wall of the metal housing.

12. The photovoltaic optimizer according to any one of claims 1 to 11, wherein the photovoltaic optimizer further comprises a mounting ear structure, the mounting ear structure is fastened to the metal housing, the mounting ear structure comprises at least one mounting hole, and the at least one mounting hole is configured to mount the photovoltaic optimizer to a target structure.

13. The photovoltaic optimizer according to claim 12, wherein the mounting ear structure and the metal housing are of an integrated structure.

14. The photovoltaic optimizer according to any one of claims 1 to 13, wherein
the photovoltaic optimizer further comprises a connection structure, and the connection structure is configured to fasten the end cover to the metal housing.

15. A photovoltaic power generation system, comprising the photovoltaic optimizer according to any one of claims 1 to 14 and a photovoltaic module, wherein an output end of the cable of the photovoltaic optimizer extends out of the metal housing to form a connector, and the connector is configured to connect the photovoltaic module.
